Europäisches Patentamt

European Patent Office

Office européen des brevets

(11) Veröffentlichungsnummer: **0 151 719**
**A2**

(12) **EUROPÄISCHE PATENTANMELDUNG**

(21) Anmeldenummer: **84114639.2**

(22) Anmeldetag: **01.12.84**

(51) Int. Cl.⁴: **H 01 F 7/22**

(30) Priorität: **06.12.83 DE 3344047**

(43) Veröffentlichungstag der Anmeldung:
**21.08.85 Patentblatt 85/34**

(84) Benannte Vertragsstaaten:
**CH DE FR GB IT LI NL**

(71) Anmelder: **BBC Aktiengesellschaft Brown, Boveri & Cie.**
**Haselstrasse**
**CH-5401 Baden(CH)**

(72) Erfinder: **Dustmann, Cord-Henrich, Dr. Dipl.-Phys.**
**Diemstrasse 10**
**D-6940 Weinheim(DE)**

(72) Erfinder: **Schmid, Thomas, Dipl.-Ing.**
**Schaffhauser Strasse 435**
**CH-8050 Zürich(CH)**

(74) Vertreter: **Kempe, Wolfgang, Dr. et al,**
**c/o Brown, Boveri & Cie AG Postfach 351**
**D-6800 Mannheim 1(DE)**

(54) Magnetsystem für einen Kernspintomograph.

(57) Es wird ein klinikfreundliches Magnetsystem für einen Kernspintomographen mit aus supraleitenden Leitern gewickelter, heliumgekühlter Spule (12, 13, 14, 15, 16) vorgeschlagen, das kompakt gebaut ist, ein geringes Streufeld aufweist, wirtschaftlich betreibbar ist und eine einfache Bedienung erlaubt. Das Magnetsystem ist gekennzeichnet durch eine Eisenabschirmung (30), indirekte Kühlung und eine Flußpumpe (32) zur Stromversorgung.

Fig. 1

0151719

|

BBC Aktiengesellschaft
BROWN,BOVERI & CIE
Baden/Schweiz                                    6. Dez. 1983
Mp.Nr. 669/83                                    ZPT/P2-La/Hr

Magnetsystem für einen Kernspintomograph

Die Erfindung betrifft ein Magnetsystem für einen Kernspintomographen mit aus supraleitenden Leitern gewickelten, heliumgekühlten Spulen.

Die Kernspintomographie benutzt die durch Kernspinresonanz erzeugten Signale zur Bildgebung. Hierfür ist das
Vorhandensein eines homogenen Magnetfeldes erforderlich.
Insbesondere zur Bildgebung vom Inneren des menschlichen
Körpers sind freie Bohrungen des Magnetsystems in der
Größenordnung von 1 m Durchmesser notwendig. Um bei diesen großen Abmessungen eine magnetische Induktion von
größer als 0,5 T zu erreichen, ist es vorteilhaft,
supraleitende Magnete einzusetzen, die bei Verwendung
von supraleitenden Schaltern auch eine hohe zeitliche
Konstanz ermöglichen.

Die Spulengeometrie der supraleitenden Magnete ist im
Hinblick auf größtmögliche Magnetfeldhomogenität optimiert.

669/83

2

0151719

Es sind Magnetsysteme für Kernspintomographie bekannt, deren Spulen aus supraleitendem Draht gewickelt sind. Die Spulen sind in einem mit flüssigem Helium gefüllten Druckbehälter eingebaut. Das freie Volumen des Behälters ist so bemessen, daß ein Nachfüllen des verdampften Heliums mit dem Nachfüllen des gespeicherten Stromes zeitlich zusammenfällt. Das aus dem Badkryostat verdampfende Helium wird in die Luft abgeblasen und ist damit verloren, was die Betriebskosten beeinflußt. Der Heliumbehälter ist von ein oder mehreren Kälteschilden umgeben. Ein Vakuumbehälter sorgt für das notwendige Isoliervakuum.

Der Betriebsstrom wird über abgasgekühlte Stromzuführungen der Spule zugeführt. Zur Verringerung der Kryoverluste wird während der Speicherzeit die Stromzuführung aus dem Heliumbad herausgezogen und muß für jede Veränderung des Betriebsstromes wieder abgesenkt werden, d.h. in elektrischen Kontakt mit der supraleitenden Spule gebracht werden. Jede für eine Stromänderung notwendige Hebe- und Senkoperation der Stromzuführung bedingt zusätzlichen Heliumverbrauch und ist als von Fachpersonal durchzuführende kritische Operation einzustufen. Eine einfache Einstellung des Stromes und damit des Magnetfeldes durch Knopfbedienung ist nicht möglich.

Die Erschwernisse bei der Stromeinstellung machen eine hohe Haltezeit des Stromes (Zeitkonstante) wünschenswert. Diese ist proportional dem Quotienten aus Spuleninduktivität und dem durch Kontakte usw. verbleibenden Widerstand im Kreis der supraleitenden Spule und eines supraleitenden Schalters. Für eine hohe Haltezeit muß die Spuleninduktivität möglichst groß gewählt werden. Eine hohe Spuleninduktivität widerspricht jedoch den Forderungen nach Quenchsicherheit (Sicherheit bei unbeabsichtigtem Übergang in die Normalleitung).

Die bekannte Spulengeometrie und die große Spuleninduktivität führen insbesondere bei im Nutzvolumen höheren gewünschten Feldstärken zu sehr weitreichenden magnetischen Streufeldern, welche eine Reihe von Nachtteilen nach sich ziehen:
Eisen der Umgebung, z.B. in Betonwänden, stört die Feldhomogenität, so daß eine Korrektur durch Korrekturspulen notwendig ist. Die Störung der Feldhomogenität durch sich bewegenden Eisenkörper (z.B. vorbeifahrende Fahrzeuge) ist nur sehr aufwendig durch große, magnetisch geschirmte Räume möglich. Magnetbänder und Bildschirme müssen in großem Abstand gehalten werden. Ferner werden Herzschrittmacher gestört.

Wegen der beschriebenen Probleme und Nachteile der bekannten Geräte, wurden diese bisher lediglich in labormäßigem Betrieb unter Aufsicht von gerätetechnisch geschultem Fachpersonal verwendet. Durch das Fachpersonal wurden insbesondere Stromänderungen und Nachfüllen des flüssigen Heliums vorgenommen.

Aufgabe der Erfindung ist es, ein klinikfreundliches Magnetsystem für einen Kernspintomographen zu schaffen, dessen Streufeld möglichst klein ist, dessen Feldhomogenität umgebungsunabhängig ist, dessen Stromeinstellung durch ein einfaches Einstellelement (Einstellknopf) erfolgen kann und eine kurzfristige Veränderbarkeit der Magnetfeldstärke zuläßt, das keine Heliumgasverluste aufweist und kein häufiges Nachfüllen von flüssigem Helium erfordert und das geringstmögliche Abmessungen aufweist.

Gemäß der Erfindung wird diese Aufgabe dadurch gelöst, daß die Spulen durch eine magnetische Abschirmung zur Verminderung des Streuflusses umgeben sind, daß die supraleitende Wicklung durch einen geschlossenen Heliumkreislauf indirekt gekühlt wird und daß der Betriebsstrom über eine Flußpumpe den supraleitenden Spulen zuführbar ist. Durch die indirekte Kühlung der Wicklung
kann auf eine bisher übliche Badkühlung verzichtet werden, bei der der Heliumbehälter mit Vorratsvolumen zusätzlichen Raum beansprucht. Ein Kryoverluste verursachender Heliumdom im Kryostaten entfällt. Dies macht es
möglich, eine Abschirmung sehr eng um die Magnetspulen
anzuordnen, so daß sich deren Ausmaße in vertretbaren
Grenzen halten.

Die Kälteleistung kann bei forcierter, indirekter Kühlung entweder von einem Minirefrigerator, wie er beispielsweise durch die Patentanmeldung Mp.Nr. 668/83 mit
gleichem Zeitrang beschrieben wird, oder von einer entsprechend dimensionierten Kälteanlage aufgebracht werden. Minirefrigeratoren sind billiger und einfacher in
der Handhabung als Kälteanlagen, die Expansionsmaschinen
enthalten.

Die indirekte Kühlung läßt keine für den Dauerstrombetrieb zur Reduktion des Kälteleistungsbedarfs aus dem
Heliumbad herausziehbare Stromzuführungen zu. Deshalb
wird die Möglichkeit der indirekten Kühlung des Magneten, insbesondere bei Verwendung eines 3-stufigen Minirefrigerators, erst durch den Einsatz einer Flußpumpe
geöffnet. Diese erfordert lediglich Zuleitungen mit geringem Querschnitt, die einen geringeren Strom bei höherer Spannung aufnehmen. Die Flußpumpe wird thermisch an
den Kühlkreislauf angekoppelt und reduziert die Stromzuführungsverluste soweit, daß ein Minirefrigerator zur
Kühlung ausreicht. Abgasgekühlte Stromzuführungen, die
entsprechende Heliumverluste verursachen, sind überflüssig.

Wegen der leichten Stromregulierbarkeit, die über Steuerung der Flußpumpe mittels Knopfbedienung möglich ist, kann auf eine besonders hohe Induktivität der Magnetspule verzichtet werden. Es ist eher ein hoher Betriebsstrom wünschenswert, so daß die Quenchsicherheit leichter gewährleistet ist.

Ein weiterer Vorteil der Erfindung ist darin zu sehen, daß die indirekt gekühlten Spulen im Vakuumbehälter frei zugänglich sind. Hierdurch können Korrekturwindungen nach Inbetriebnahme und Vermessen der Spule nachträglich angebracht werden, ohne daß in aufwendiger Weise ein Kryobehälter entfernt (aufgeschweißt) zu werden brauchte.

Die magnetische Abschirmung wird vorzugweise als Eisenjoch ausgebildet, deren Dicke auf den magnetischen Streufluß der Spulen abgestimmt ist. Schwingungen, die von dem ständig in Betrieb befindlichen Kryogenerator für die indirekte Kühlung ausgehen, werden am massiven Eisenjoch abgefangen.

Eine weitere Ausgestaltung sieht vor, daß die supraleitenden Spulen von einem vakuumdichten Mantel aus ferritischem Stahl umgeben sind, und daß um den Mantel Eisensegmente als magnetische Abschirmung angeordnet sind. Damit wird der Vakuumbehälter in die magnetische Abschirmung miteinbezogen. Er muß nicht vollständig aus austenitischem (unmagnetischen) Stahl bestehen, wodurch sich eine Kostenreduktion und eine leichtere Verarbeitung ergeben. Durch die leichtere Schweißbarkeit läßt sich die erforderliche Leckdichtigkeit besser realisieren. Die Verwendung von Eisensegmenten hat den Vorteil, daß sich der magnetische Schirm für die Montage leichter transportieren läßt. Die Eisensegmente werden in Modulbauweise nebeneinander und/oder übereinander gestapelt,

0151719

bis die erforderliche Abschirmdicke erreicht ist.

Um im segmentierten Eisenjoch Luftspalte zu vermeiden, ist es zweckmäßig, die einander zugewandten Flächen zwischen den Eisensegmenten derart auszurichten, daß sie parallel zu den Magnetfeldlinien liegen. Ferner ist es vorteilhaft, Segmente, durch welche Zuleitungen zu den Spulen geführt sind, verstärkt auszuführen, so daß sich bei diesen Segmenten keine Erhöhung der Flußdichte einstellt.

Zur magnetischen Abschirmung können in vorteilhafter Weise auch supraleitende Abschirmspulen verwendet werden.

Die indirekte Kühlung der supraleitenden Wicklung erfolgt vorzugsweise entweder durch Verwendung von supraleitenden, von dem Kühlmedium durchströmten Hohlleitern oder durch das Aufbringen eines zusätzlichen Kühlrohrsystems, das mit der supraleitenden Wicklung in gutem Wärmekontakt steht. Der Hohlleiter oder das Kühlrohrsystem wird im geschlossenen Kreislauf an eine kontinuierlich arbeitende Kälteanlage angeschlossen, wodurch Heliumgasverluste gänzlich vermieden werden. Ein Heliumbehälter ist überflüssig. Die Kälteschilde werden ebenso von der kontinuierlich arbeitenden Kälteanlage gekühlt.

Das erste Abkühlen kann mittels Heliumheber erfolgen. Wenn für das erstmalige Abkühlen der Spulen die Durchtrittsöffnungen der Hohlleiter bzw. des Kühlrohrsystems zu klein sind, ist es zweckmäßig, ein zusätzliches Kühlrohrsystem mit größerem Querschnitt vorzusehen. Vorteilhaft ist es, die Zuleitungen des zusätzlichen Kühlrohrsystems als Aufhängung für das Magnetsystem zu verwenden.

Besonders vorteilhaft ist die kontinuierliche Kühlung eines zusätzlichen Kühlrohrsystems durch Zwei-Phasenhelium unter Ausnützung der natürlichen Konvektion. Eine entsprechende Ausbildung des Kühlsystems wird durch die Patentanmeldung Mp.Nr. 668/83 mit gleichem Zeitrang beschrieben.

Vorzugsweise besteht die Flußpumpe aus einem Transformator mit supraleitender Sekundärwicklung und wenigstens einem supraleitenden Schalter. Supraleitende Schalter sind als steuerbare Gleichrichterelemente den Halbleitergleichrichtern vorzuziehen, da letztere sehr hohe Verluste zur Folge haben.

Der Transformator wird zweckmäßigerweise als toroidaler Lufttransformator ausgebildet. Ein derartiger Transformator weist eine besonders gute Kopplung zwischen Primär- und Sekundärwicklung auf und erzeugt keine Streufelder. Die Vermeidung eines Eisenkernes ist vorteilhaft, da sich ein Eisenkern störend auf das Magnetfeld des Magnetsystems des Kernspintomographen auswirken könnte.

Zweckmäßigerweise wird die Sekundärwicklung des Transformators mit kleiner Induktivität ausgelegt, da das Verhältnis von dieser Sekundärinduktivität zur Induktivität der magnetfelderzeugenden Spulen klein sein muß, um eine hohe Wirksamkeit der Flußpumpe zu ermöglichen.

Anhand der Zeichnung, in der ein Ausführungsbeispiel der Erfindung gezeigt ist, sollen die Erfindung sowie weitere vorteilhafte Ausgestaltungen und Weiterbildungen näher erläutert werden.

Es zeigt:
Fig. 1     den Querschnitt durch einen Kernspintomographen mit erfindungsgemäßem Magnetsystem in schematischer Darstellung und

Fig. 2     das Ersatzschaltbild für eine Flußpumpenanordnung.

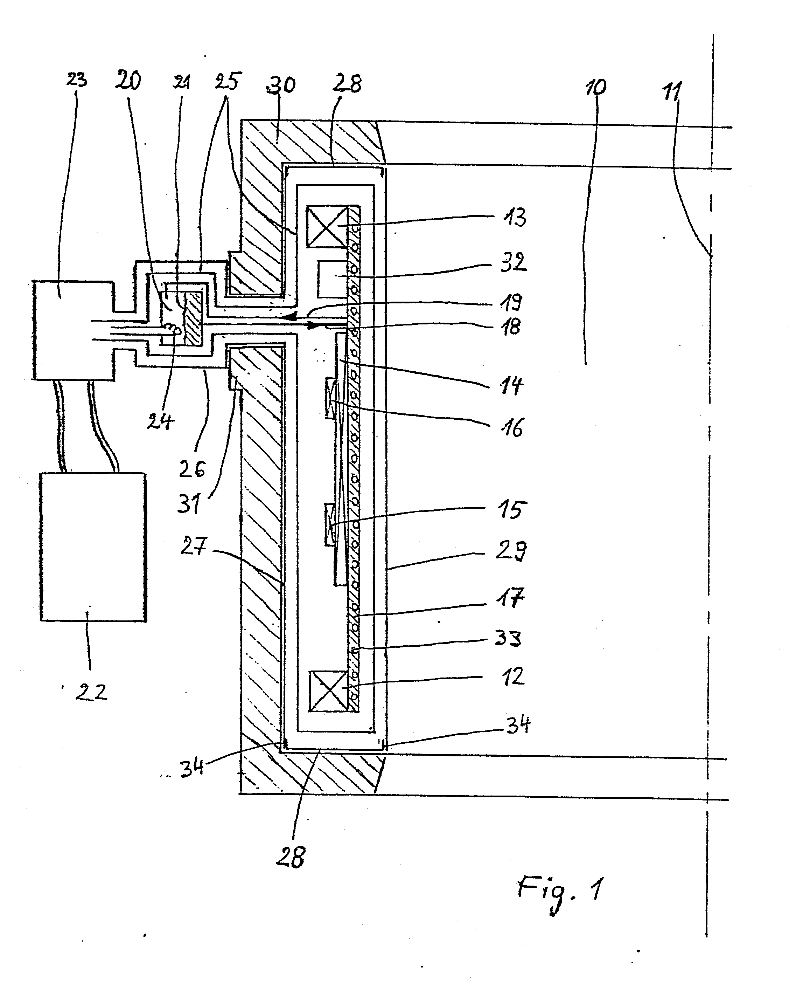

Die Figur 1 zeigt eine Hälfte einer zylindrischen Untersuchungsöffnung 10 sowie die Zylinderachse 11. Konzentrisch zur Zylinderachse 11 sind drei supraleitende Hauptfeldspulen 12,13,14 sowie zwei Korrekturspulen 15,16 angeordnet. Die elektrischen Anschlußleitungen für die Hauptfeldspulen 12,13,14 und Korrekturspulen 15,16 sind nicht dargestellt. Die Spulen können beispielsweise elektrisch hintereinander geschaltet sein. Die Spulenanordnung ist derart gewählt, daß sich innerhalb der Untersuchungsöffnung 10 ein homogenes Magnetfeld ausbildet.

Die Hauptfeldspulen 12,13,14 werden durch einen Spulenträger 17 getragen. Dieser besteht aus einem zylindrischen Wickelkörper, welcher ein Kühlrohrsystem 33 aufweist. Ein derartiges Kühlrohrsystem 33 ist in der Patentanmeldung Mp.Nr. 668/83 mit gleichem Zeitrang beschrieben. Das Kühlrohrsystem 33 ist über eine Vorlaufleitung 18 und eine Rücklaufleitung 19 mit einem Heliumvorratsgefäß 20 verbunden. Die Rücklaufleitung 19 endet im Vorratsgefäß 20 oberhalb des Flüssigkeitsspiegels 21 des flüssigen Heliums. Die Kühlung des Spulenträgers 17 erfolgt durch natürliche Konvektion, in dem durch die Vorlaufleitung 18 flüssiges Helium in das Kühlrohrsystem 33 eintritt und durch die Rücklaufleitung 19 gasförmiges (evtl. auch flüssiges) Helium in das Vorratsgefäß 20 zurückströmt.

Das gasförmige Helium im Vorratsgefäß 20 wird durch einen 3-stufigen Minirefrigerator wieder kondensiert.

Der Minirefrigerator besteht aus einem mit einem Kompressor 22 verbundenen Kaltkopf 23, dessen Ende 24 in den Gasraum des Vorratsgefäßes 20 ragt.

Die auf die Temperatur des flüssigen Helium heruntergekühlten Teile (supraleitende Spulen, Spulenträger, Vor- und Rücklaufleitung, Heliumvorratsgefäß) sind durch Kälteschilde 25 umgeben, welche ebenfalls durch den dreistufigen Minirefrigerator gekühlt werden. Die Kälteschilde 25 sind ihrerseits von einem Vakuummantel 26,27,28,29 umgeben.

Der Vakuummantel 27,28,29, der die supraleitenden Spulen umschließt, besteht aus mehreren, vakuumdicht aneinander geflanschten Teilen. Das innere zylindrische Teil 29 besteht aus austenitischem Stahl, so daß der Durchtritt des Magnetfeldes nicht behindert wird. Ein äußerer zylindrischer Teil 27 sowie zwei ringförmige Stirnteile 28 bestehen aus ferritischem Stahl und tragen zur Abschirmung eines nach außen tretenden Magnetfeldes bei. Die einzelnen Teile des Vakuummantels sind durch vakuumdichte Flansche 34 miteinander verbunden.

Außerhalb des Vakuummantels befindet sich ein Eisenjoch 30. Dieses ist aus einer Vielzahl in Umfangsrichtung des äußeren Vakuummantels 27 nebeneinander angeordneten Segmenten aufgebaut, welche sich axial erstrecken. In Fig. 1 ist lediglich der Querschnitt durch ein Segment 30 dargestellt. Dieses Segment 30 weist im Bereich der Kühlleitungsdurchführungen eine Eisenverstärkung 31 auf, durch die eine Erhöhung der magnetischen Flußdichte in diesem Bereich vermieden wird. Die Größe der Eisensegmente 30 ist so gewählt, daß der Einsatz von Spezialhubmitteln bei der Montage vermieden wird.

Das Gerät gemäß Figur 1 ist demontierbar, so daß die Korrekturspulen 15,16 nach Inbetriebnahme und Vermessung der Hauptfeldspulen 12,13,14 ausgelegt und eingebaut werden können.

Mit dem Spulenträger 17 stehen die Elemente einer Flußpumpe 32, die auf tiefe Temperaturen heruntergekühlt sein müssen (Primär- und Sekundärinduktivität, supraleitende Schalter) in thermischem Kontakt.

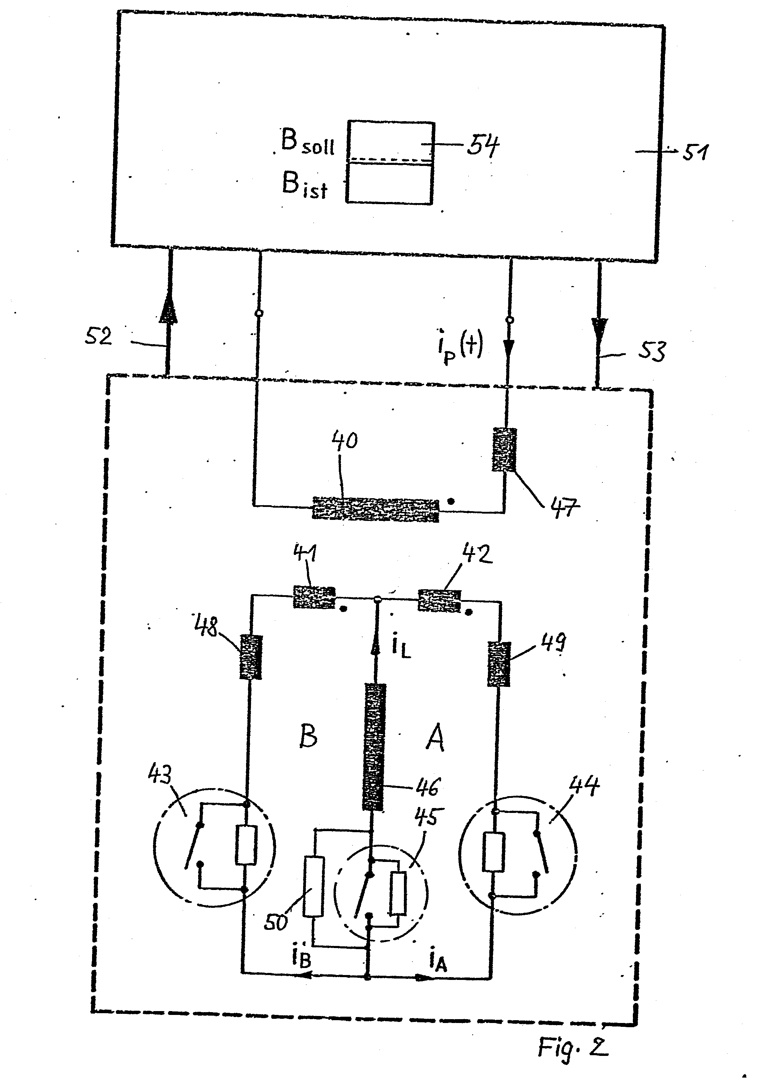

Die Figur 2 zeigt ein Ersatzschaltbild der Flußpumpe 32. Flußpumpen dieser Art wurden beispielsweise in zwei Auf-sätzen in Cryogenics 21, Seiten 195 bis 206 und Seiten 267 bis 277 (1981) beschrieben. Die Flußpumpe besteht im wesentlichen aus einem Transformator mit supraleitender Primärinduktivität 40 und supraleitender Sekundärinduktivität 41,42, drei supraleitenden Schaltern 43,44,45 und der supraleitenden Wicklung (Lastinduktivität) 46. Die Lastinduktivität 46 entspricht den drei Hauptfeldspulen 12,13,14 gemäß Fig. 1. In dem Ersatzschaltbild gemäß Fig. 2 sind ferner die Streuinduktivitäten 47,48,49 der Primärinduktivität 40 und der Sekundärinduktivität 41,42 dargestellt.

Die supraleitenden Schalter sind symbolisch dargestellt. Sie bestehen im wesentlichen aus einem supraleitenden Leiter, der durch eine Heizwicklung erwärmbar ist. Bei abgekühltem Leiter ist dieser supraleitend, bei erwärmtem Leiter ist er nornmalleitend und weist einen endlichen Widerstand auf.

Die beiden supraleitenden Schalter 43 und 44 dienen dem Hochpumpen des Laststromes $i_L$ der Lastinduktivität 46. Der supraleitende Schalter 45 ist ein Schutzelement für die Lastinduktivität 46. Er ist geschlossen, sofern die Lastinduktivität 46 vollständig im supraleitenden Zustand ist. Geht diese jedoch wenigstens teilweise in den Normalleitungszustand über, so wird der Schutzschalter 45 geöffnet (durch Heizen des entsprechenden Leiterabschnittes). Der Stromfluß im Kreis der Lastinduktivität 46 wird über den Schutzwiderstand 50 geleitet und durch diesen begrenzt, so daß eine Beschädigung der Lastinduktivität 46 durch Erwärmung des normalleitenden Bereiches vermieden wird.

Der Transformator 40,41,42 und die supraleitenden Schalter 43,44,45 sind, wie in Fig. 1 angedeutet wurde, thermisch an den Spulenträger 17 als Flußpumpe 32 angekoppelt.

Die Flußpumpe wird durch eine Steuereinrichtung 51 gesteuert. Die Steuereinrichtung 51 erfaßt über Meßwertleitungen 52 den Zustand der Flußpumpe (z.B. Temperatur, Laststrom $i_L$, Zustand der supraleitenden Schalter). Über Steuerleitungen 53 beeinflußt die Steuereinrichtung 51 die Flußpumpe, insbesondere die supraleitenden Schalter 43,44,45.

Über einen Einstellknopf 54 wird der Steuereinrichtung ein für die Untersuchungsöffnung 10 gewünschter Induktionssollwert $B_{soll}$ vorgegeben. Ferner wird in der Untersuchungsöffnung 10 der Induktionsistwert $B_{ist}$ gemessen und der Steuereinrichtung 51 zugeführt. Gemäß dem Soll-Istvergleich wird der Primärstrom $i_P$ (t) und der Zustand der supraleitenden Schalter 43,44,45 eingestellt.

A n s p r ü c h e

1. Magnetsystem für einen Kernspintomographen mit heliumgekühlter Wicklung aus supraleitenden Leitern, dadurch gekennzeichnet, daß die Wicklung (12,13,14,15,16) durch eine magnetische Abschirmung (30) zur Verminderung des Streuflusses umgeben ist, daß die supraleitende Wicklung (12,13,14,15,16) durch einen geschlossenen Heliumkreislauf indirekt kühlbar ist und daß der Betriebsstrom über eine Flußpumpe (32) der supraleitenden Wicklung (12,13,14,15,16) zuführbar ist.

2. Magnetsystem nach Anspruch 1, dadurch gekennzeichnet, daß die magnetische Abschirmung als Eisenjoch (30) ausgebildet ist, dessen Dicke auf den magnetischen Streufluß der supraleitenden Wicklung (12,13,14,15,16) abgestimmt ist.

3. Magnetsystem nach Anspruch 1 oder 2, dadurch gekennzeichnet, daß die supraleitende Wicklung (12,13,14,15,16) von einem vakuumdichten Mantel (27,28) aus ferritischem Stahl umgeben ist, und daß um den Mantel (27,28) Eisensegmente (30) als magnetische Abschirmung angeordnet sind.

4. Magnetsystem nach Anspruch 3, dadurch gekennzeichnet, daß die einander zugewandten Flächen zwischen den Eisensegmenten (30) derart ausgerichtet sind, daß sie parallel zu den Magnetfeldlinien liegen.

5. Magnetsystem nach Anspruch 3 oder 4, dadurch gekennzeichnet, daß die elektrischen Zuleitungen zur supraleitenden Wicklung (12,13,14,15,16) sowie die

669/83                              13              **0151719**

Kühlleitungen (18,19) durch verstärkte Segmente (30) geführt sind.

6. Magnetsystem nach einem der Ansprüche 1 bis 5, dadurch gekennzeichnet, daß zur magnetischen Abschirmung supraleitende Abschirmwicklungen verwendet werden.

7. Magnetsystem nach einem der Ansprüche 1 bis 6, dadurch gekennzeichnet, daß zur indirekten Kühlung die supraleitenden Leiter als von dem Kühlmedium durchströmte supraleitende Hohlleiter ausgebildet sind.

8. Magnetsystem nach einem der Ansprüche 1 bis 7, dadurch gekennzeichnet, daß die indirekte Kühlung durch ein Kühlrohrsystem (33) erfolgt, das mit der supraleitenden Wicklung (12,13,14,15,16) in gutem Wärmekontakt steht.

9. Magnetsystem nach einem der Ansprüche 7 oder 8, dadurch gekennzeichnet, daß eine zusätzliche Kühlung zum erstmaligen Kühlen vorgesehen ist, die als Kühlwicklung mit großem Querschnitt ausgelegt ist und deren Zuleitungen als Aufhängung für das Magnetsystem dienen.

10. Magnetsystem nach einem der Ansprüche 7 bis 9, dadurch gekennzeichnet, daß die Kühlung der Leiter durch Zwei-Phasenhelium unter Ausnützung der natürlichen Konvektion erfolgt.

11. Magnetsystem nach einem der Ansprüche 1 bis 10, dadurch gekennzeichnet, daß die Flußpumpe (32) aus einem Transformator (40,41,42) mit supraleitender Sekundärwicklung (41,42) und wenigstens einem supraleitenden Schalter (43,44,45) besteht.

12. Magnetsystem nach Anspruch 11, dadurch gekennzeichnet, daß der Transformator ein toroidaler Lufttransformator ist.

Fig. 1

0151719

Fig. 2